# EUROPÄISCHE PATENTSCHRIFT

(11) **EP 0 766 380 B1**
(45) Veröffentlichungstag und Bekanntmachung des Hinweises auf die Patenterteilung: **13.06.2001**
(21) Anmeldenummer: 96114183.5
(22) Anmeldetag: 04.09.1996
(51) Int. Cl.: H03F 3/19, H03D 7/12, H03B 5/18, H03F 3/195

(54) **Integrierter Mikrowellen-Silizium-Baustein**
Integrated microwave silicon component
Composant micro-onde en silice à circuit intégré

(30) Priorität: 29.09.1995 DE 19536431
(43) Veröffentlichungstag der Anmeldung: 02.04.1997
(73) Patentinhaber: Infineon Technologies AG, 81669 München (DE)
(72) Erfinder: Lohninger, Gerhard, 81549 München (DE)

(56) Entgegenhaltungen:
- DE-B- 1 933 933
- DE-B- 2 347 711
- US-A- 3 271 685
- SUWAKI H ET AL: "AN MMIC LOCAL OSCILLATOR FOR 16-QAM DIGITAL MICROWAVE RADIO SYSTEMS" IEEE TRANSACTIONS ON MICROWAVE THEORY AND TECHNIQUES, Bd. 43, Nr. 6, 1.Juni 1995, Seiten 1230-1235, XP000511417

## Beschreibung

Die Erfindung betrifft einen integrierten Mikrowellen-Silizium-Baustein mit einer Transistorschaltung, wie sie im Oberbegriff des Anspruchs 1 beschrieben ist.

Eine Vielzahl verschiedener Silizium MMIC-Bauteine (Microwave Monolithic Integrated Circuit) sind bekannt. Dabei wird üblicherweise für jede Anwendung ein neues Bausteindesign entwikkelt, welches mehr oder weniger kompliziert aufgebaut und an den jeweiligen Zweck angepaßt ist.

Eine Transistorschaltung der eingangs genannten Art ist aus US 3,271,685 A bekannt. Ferner ist in DE 19 33 933 B beschrieben, Basis und Kollektor des Eingangstransistors eines Breitbandverstärkers über einen Widerstand zu verbinden. Der Erfindung liegt die **Aufgabe** zugrunde, einen Baustein der eingangs genannten Art zu schaffen, der vielseitig einsetzbar ist und sich durch ein besonders günstiges Design auszeichnet.

Die Lösung dieser Aufgabe erfolgt gemäß den kennzeichnenden Merkmalen des Anspruchs 1. Vorteilhafte Weiterbildungen sind in den Unteransprüchen beschrieben.

Nach dem Grundgedanken der Erfindung ist die Basis eines ersten Transistors an den Schaltungseingang angeschlossen, die Basis eines zweiten Transistors mit dem Kollektor des ersten Transistors verbunden, der Emitter des zweiten Transistors mit einem ersten Schaltungsausgang verbunden, der Kollektor des ersten Transistors über einen Widerstand mit einem zweiten Schaltungsausgang verbunden, verbindet jeweils ein Widerstand Basis und Kollektor des ersten Transistors und des zweiten Transistors, ein unteres Potential liegt am Emitter des ersten Transistors und ein oberes Potential am Kollektor des zweiten Transistors an.

Durch das erfindungsgemäße Schaltungsdesign wird ein universal einsetzbarer Baustein geschaffen, der in erster Linie als rauscharmer 50 Ohm-Breitband-Vorverstärker aber auch als Oszillator oder Mischer eingesetzt werden kann. Durch die vielseitige Verwendbarkeit und die günstige Schaltungsauslegung wird außerdem eine hohe Kostenersparnis hinsichtlich des Maskenlayouts und der Prüftechnik erreicht. Abhängig von den Anforderungen des Benutzers sind eine Vielzahl von Anwendungsmöglichkeiten für diesen Baustein möglich.

Ein weiterer Vorteil ist darin zu sehen, daß der Baustein in einem Mikrowellen-Kunststoff- oder Plastikgehäuse mit geringen Abmessungen gekapselt werden kann. Durch die erfindungsgemäße Auslegung des Bausteins ist bei den verschiedenen Anwendungen auch nur noch eine geringe Anzahl von externen Bauelementen nötig.

In einer bevorzugten Weiterbildung der Erfindung wird ein RC-Glied zwischen Basis und Kollektor des ersten Transistors geschaltet. Auf diese Weise wird eine Verbesserung der Eingangsanpassung erreicht.

Durch Verbindung des ersten und des zweiten Schaltungsausgangs durch eine Kapazität kann auf einfache Weise ein rauscharmer Breitband-Verstärker an den zusammengeschalteten Schaltungsausgängen erzeugt werden. Eine andere Möglichkeit zur Ausbildung eines solchen Verstärkers besteht darin, an den ersten Schaltungsausgang einen Widerstand anzuschließen und an diesem die verstärkte Hochfrequenz abzugreifen. Ebenso erhält man einen rauscharmen Breitband-Verstärker auch auf günstige Weise durch Abgriff des verstärkten Hochfrequenzsignals hinter einem zusätzlichen Widerstand am zweiten Schaltungsausgang.

In einer anderen bevorzugten Anwendung kann der erfindungsgemäße Baustein als Mischer verwendet werden. Dabei wird der lokale Oszillator am ersten Schaltungsausgang eingespeist. Am Abgriffspunkt des oberen Potentials wird über ein Anpaßnetzwerk die Zwischenfrequenz abgenommen und über eine Spule eine Vorspannung angelegt.

Eine Oszillatoranwendung ist mit dem erfindungsgemäßen Baustein ebenfalls möglich. Dabei wird über den zweiten Schaltungsausgang eine Rückkopplung zum Schaltungseingang hergestellt und am ersten Schaltungsausgang über einen Kondensator der Oszillatorausgang abgegriffen.

Nachfolgend werden ein Ausführungsbeispiel und sechs Anwendungsbeispiele für den erfindungsgemäßen Baustein anhand einer Zeichnung näher erläutert. Im einzelnen zeigen die schematischen Darstellungen in:
- Fig. 1: eine schematische Darstellung des erfindungsgemäßen Bauelements;
- Fig. 2: eine erste Version eines rauscharmen Breitband-Verstärkers;
- Fig. 3: eine zweite Version eines rauscharmen Breitband-Verstärkers;
- Fig. 4: eine dritte Version eines rauscharmen Breitband-Verstärkers;
- Fig. 5: eine vierte Version eines rauscharmen Breitband-Verstärkers;
- Fig. 6: eine Mischeranwendung; und
- Fig. 7: eine Oszillatoranwendung.

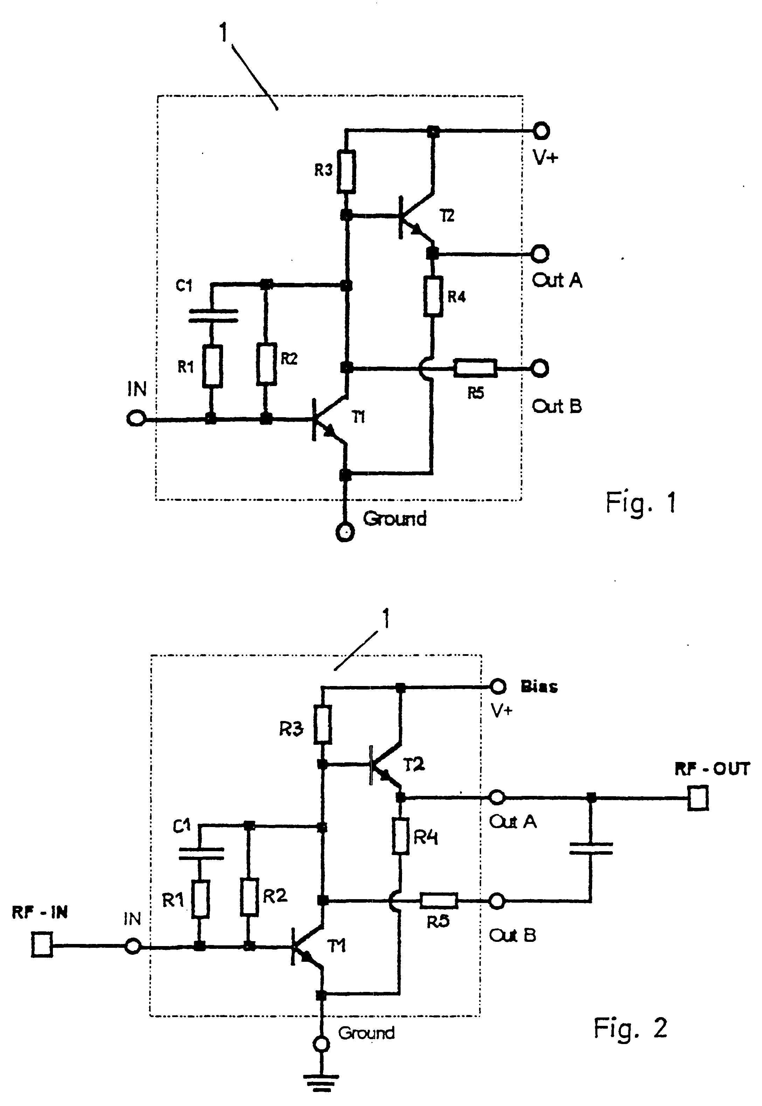

In Fig. 1 ist der erfindungsgemäße Baustein 1 dargestellt. Durch die gestrichelte Linie wird dargestellt, welche Elemente innerhalb des gekapselten Bausteins angeordnet sind. Das Schaltungskonzept sieht fünf freie Anschlüsse, nämlich den Schaltungseingang, der mit IN gekennzeichnet ist, einen ersten und einen zweiten Schaltungsausgang, die mit Out-A und Out-B bezeichnet sind, und zwei weitere Anschlüsse, an denen eine Versorgungsspannung angelegt werden kann und die mit V+ und Ground bezeichnet sind, vor. Der dargestellte Baustein 1 enthält zwei Bipolar-Transistoren, fünf Widerstände und eine Kapazität. Der Widerstand R1 und die Kapazität C1 dienen zur Verbesserung der Eingangsanpassung. Mit dem Widerstand R2 wird der Arbeitspunkt für den Transistor T1 dargestellt. Der Widerstand R3 wird gleich dreifach benutzt und dient zum einen als Kollektorwiderstand für den Transistor T1, als HF-Rückkopplung für den Transistor T2 und gleichzeitig zur Arbeitspunkteinstellung für den zweiten Transistor T2. Der Widerstand R4 hat ebenfalls mehrere Funktionen und dient zum einen als Emitterwiderstand des zweiten Transistors T2 und als DC- und HF-Gegenkopplung. Durch die Widerstände R2, R3 und R4 wird eine hohe Temperaturstabilität erreicht. Der Widerstand R5 stellt einen optionalen Rückkopplungswiderstand dar. Der Baustein ist für Betriebspannungen von 2 Volt bis 5 Volt geeignet. Dieser breite Spannungsbereich wird ebenfalls durch das erfindungsgemäße Schaltungsdesign ermöglicht.

Die Versträrkungsstrecke des ersten Transistors T1 liegt direkt am unteren Potentialanschluß, der im dargestellten Beispiel Erde entspricht. Die Verstärkungsstrecke des zweiten Transistors ist über den Widerstand R4 ebenfalls auf Erde gelegt. Die Basis des ersten Transistors liegt direkt am Schaltungseingang In, während die Basis des zweiten Transistors ebenso wie der Kollektor des ersten Transistors über den Widerstand R2 mit dem Schaltungseingang verbunden ist.

In den folgenden Figuren entspricht die Schaltung im Inneren des Kastens der in Fig. 1 beschriebenen Schaltung. Die fünf Anschlüsse ermöglichen die im folgenden dargestellten vier Vorverstärkeranwendungen mit unterschiedlichen Verstärkungs-, Anpaß- und Ausgangsleistungswerten, eine Mischer- und eine Oszillatorapplikation.

Eine erste Version eines rauscharmen Breitband-Verstärkers ist in Fig. 2 dargestellt. Zwischen den beiden Schaltungsausgängen Out-A und Out-B ist ein Kondensator geschaltet. Am Schaltungseingang IN wird ein Hochfrequenzsignal, welches mit RF-IN bezeichnet ist, eingespeist. Die Eingangsanpassung am Eingang ist im Frequenzbereich zwischen 1 GHz und 3 GHz optimal. Das verstärkte Hochfrequenz-Ausgangssignal wird an der mit RF-Out gekennzeichneten Stelle abgegriffen.

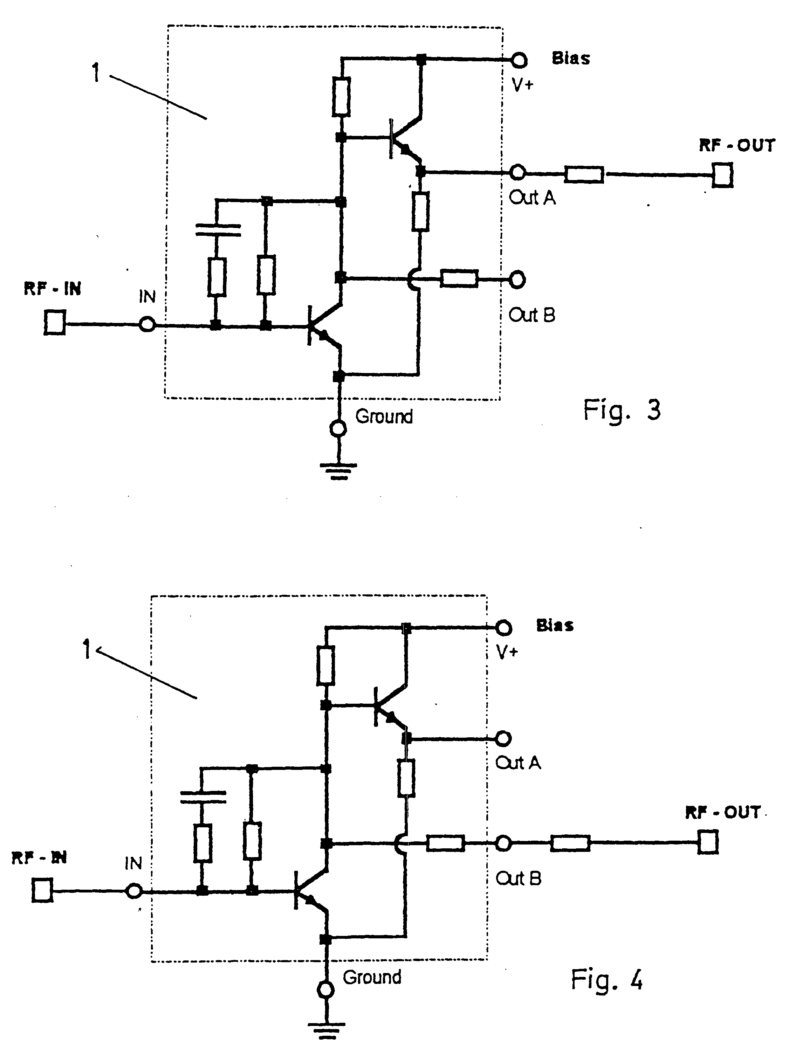

In Fig. 3 ist eine zweite Version eines rauscharmen Breitband-Verstärkers dargestellt. Die Einspeisung des Hochfreguenz-Eingangssignals erfolgt ebenso wie bei der ersten Version am Schaltungseingang IN. Die Ausgabe erfolgt am ersten Schaltungsausgang Out-A über einen seriellen niederohmigen Widerstand. Die Eingangsanpassung am Schaltungseingang ist im Frequenzbereich zwischen 50 MHz und 1,5 GHz optimal.

Eine weitere Variante ist in Fig. 4 dargestellt. Bei dieser dritten Version wird ein niederohmiger Widerstand am zweiten Schaltungsausgang Out-B zur Verbesserung der Ausgangsanpassung angeschlossen.

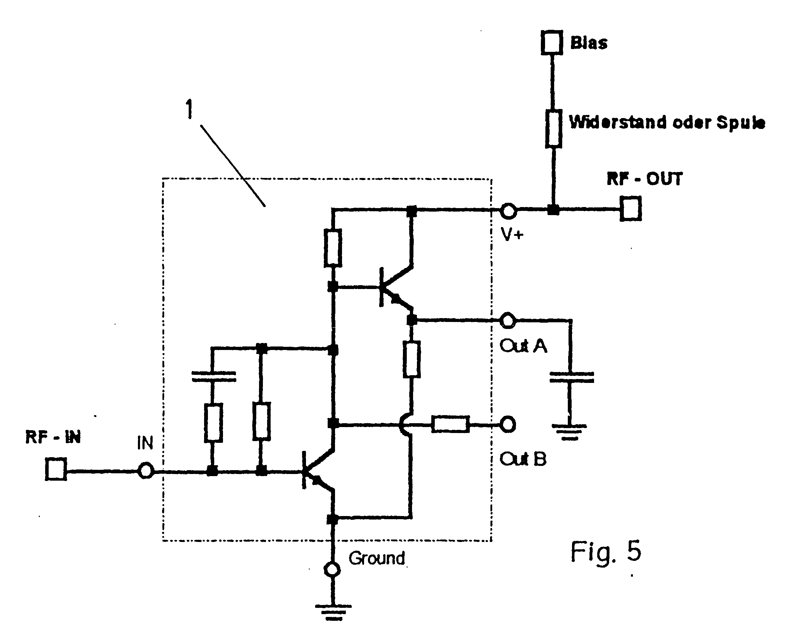

Die vierte Version eines rauscharmen Breitband-Verstärkers ist in Fig. 5 dargestellt. Diese Version zeichnet sich durch eine hohe Verstärkung aus, die von der Größe des am ersten Schaltungsausgang Out-A angeschlossenen und gegen Erde gelegten Kondensators abhängt. Das verstärkte Signal wird am V+ Port abgegriffen, an dem auch über einen Widerstand oder eine Spule die Spannungsversorgung anliegt.

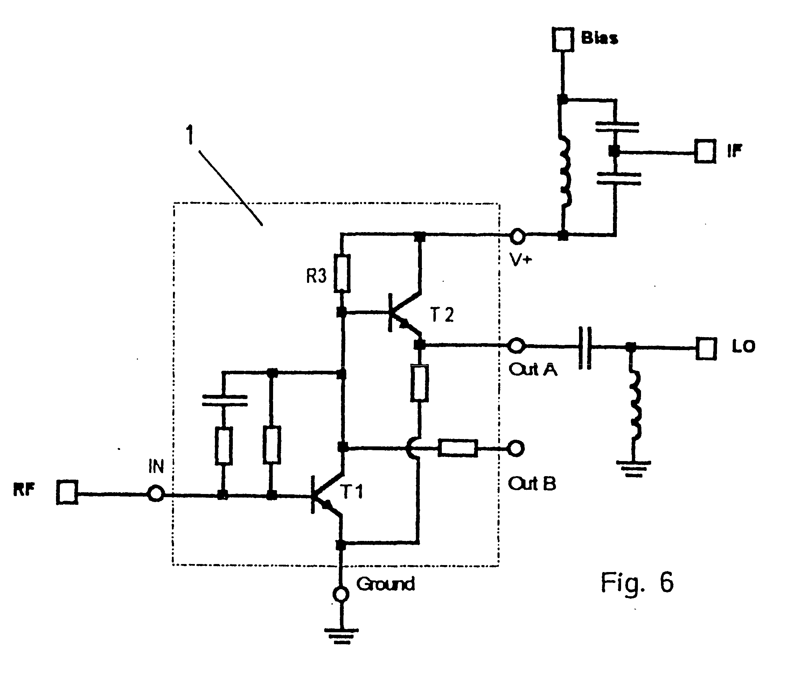

Eine Mischeranwendung ist in Fig. 6 dargestellt. Als Grundlage dieser Mischeranwendung dient das Emitter-Injection-Prinzip. Dabei wird der lokale Oszillator am ersten Schaltungsausgang Out-A eingespeist und dem Emitter des zweiten Transistors T2 zugeführt. Der Vorverstärker mit dem ersten Transistor T1 erniedrigt die Mischerrauschzahl und erhöht die Gesamtverstärkung.

Am V+ Port läßt sich über ein Anpaßnetzwerk mit zwei Kondensatoren die Zwischenfrequenz abnehmen. Die Spule für das Biasing dient dabei als Resonanzelement. Parallel zu der Spule sind zwei Kondensatoren in Reihe geschaltet, zwischen denen die Zwischenfrequenz abgenommen wird. Am ersten Schaltungsausgang ist ebenfalls ein Kondensator vorgesehen, an den eine geerdete Spule und der lokale Oszillator angeschlossen sind.

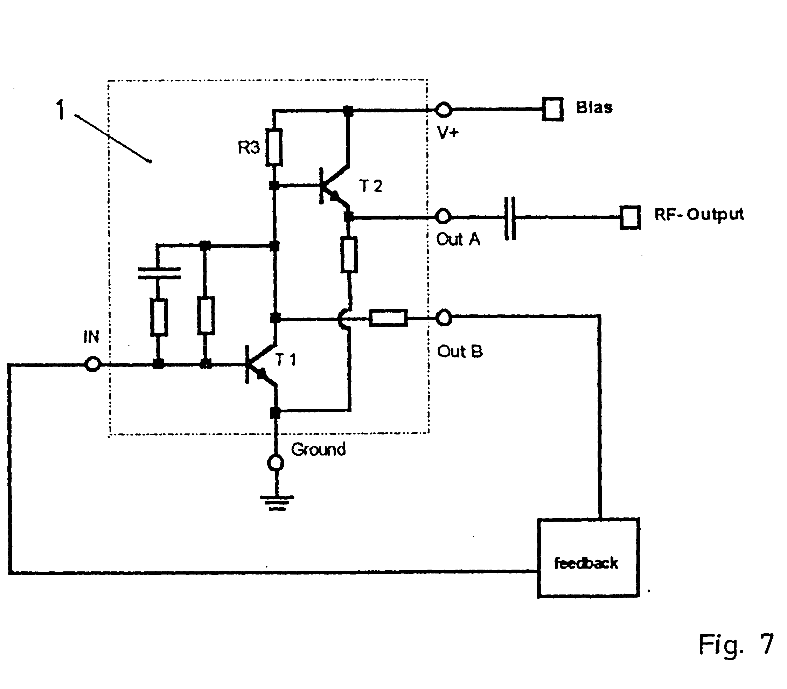

Eine Oszillatoranwendung ist beispielhaft in Fig. 7 dargestellt. Ein besonderer Vorteil dieser Anwendung ist die Pufferung des Bauteils am ersten Schaltungsausgang Out-A. Dies wird durch den Emitterfolger mit dem zweiten Transistor T2 bewerkstelligt. Die Rückkoppelstruktur kann abhängig von der Frequenz als Parallelrückkopplung oder, wie hier dargestellt, als serielle Rückkopplung realisiert werden. Dazu verwendet man dielektrische oder Koaxial-Resonatoren. Zur Erhöhung des Betriebsstroms des Transistors T2 und zur Erhöhung der Ausgangsleistung kann am ersten Schaltungsausgang Out-A ein niederohmiger Widerstand gegen Masse geschaltet werden.

## Patentansprüche

1. Integrierter Mikrowellen-Silizium-Baustein mit einer Transistorschaltung, bei welchem die Basis eines ersten Transistors (T1) an den Schaltungseingang (IN) angeschlossen ist, die Basis eines zweiten Transistors (T2) mit dem Kollektor des ersten Transistors (T1) verbunden ist, der Emitter des zweiten Transistors (T2) mit einem ersten Schaltungsausgang (Out-A) verbunden ist,
ein Widerstand (R2, R3) zwischen Basis und Kollektor des ersten Transistors (T1) und des zweiten Transistors (T2) liegt, ein unteres Potential (Ground) am Emitter des ersten Transistors (T1) und ein oberes Potential (V+) am Kollektor des zweiten Transistors (T2) anliegt,
**dadurch gekennzeichnet,**
daß der Emitter des ersten Transistors (T1) über einen Widerstand (R4) unmittelbar mit dem Emitter des zweiten Transistors (T2) verbunden ist und
der Kollektor des ersten Transistors (T1) über einen Widerstand (R5) mit einem zweiten Ausgang (Out-B) verbunden ist.

2. Integrierter Mikrowellen-Silizium-Baustein nach Anspruch 1,
dadurch **gekennzeichnet,**
daß ein RC-Glied zwischen Basis und Kollektor des ersten Transistors (T1) geschaltet ist.

3. Integrierter Mikrowellen-Silizium-Baustein nach einem der vorhergehenden Ansprüche,
dadurch **gekennzeichnet,**
daß der Baustein (1) zum Aufbau eines Verstärkers dient.

4. Integrierter Mikrowellen-Silizium-Baustein nach Anspruch 3,
dadurch **gekennzeichnet,**
daß zwischen dem ersten und zweiten Schaltungsausgang eine Kapazität geschaltet ist.

5. Integrierter Mikrowellen-Silizium-Baustein nach Anspruch 3,
dadurch **gekennzeichnet,**
daß die verstärkte Spannung am ersten Schaltungsausgang (Out-B) hinter einem seriellen Widerstand abgegriffen wird.

6. Integrierter Mikrowellen-Silizium-Baustein nach Anspruch 3,
dadurch **gekennzeichnet,**
daß die verstärkte Spannung am zweiten Schaltungsausgang (Out-B) hinter einem seriellen Widerstand abgegriffen wird.

7. Integrierter Mikrowellen-Silizium-Baustein nach Anspruch 3,
dadurch **gekennzeichnet,**
daß am ersten Schaltungsausgang (Out-A) ein Kondensator gegen Masse geschaltet ist und die Ausgabe des verstärkten Signals am oberen Potentialanschluß (V+) erfolgt.

8. Integrierter Mikrowellen-Silizium-Baustein nach Anspruch 1 oder 2,
dadurch **gekennzeichnet,**
daß der Baustein (1) als Mischer einsetzbar ist.

9. Integrierter Mikrowellen-Silizium-Baustein nach Anspruch 8,
dadurch **gekennzeichnet,**
daß am ersten Schaltungsausgang (Out-A) über eine Kapazität und eine gegen Erde gelegte Induktivität der lokale Oszillator eingespeist wird und am oberen Potentialingang (V+) über ein Anpaßnetzwerk eine Zwischenfrequenz abnehmbar ist.

10. Integrierter Mikrowellen-Silizium-Baustein nach Anspruch 1 oder 2,
dadurch **gekennzeichnet,**
daß der Baustein (1) als Oszillator einsetzbar ist.

11. Integrierter Mikrowellen-Silizium-Baustein nach Anspruch 10,
dadurch **gekennzeichnet,**
daß über den zweiten Schaltungsausgang (Out-B) eine Rückkopplung auf den Schaltungseingang (IN) stattfindet und über den zweiten Schaltungsausgang das Oszillatorausgangssignal hinter einer Kapazität abnehmbar ist.

## Claims

1. Integrated microwave silicon module having a transistor circuit, in which the base of a first transistor (T1) is connected to the circuit input (IN) the base of a second transistor (T2) is connected to the collector of the first transistor (T1), the emitter of the second transistor (T2) is connected to a first circuit output (OUT-A),
a resistor (R2, R3) is connected between the base and connector of the first transistor (T1) and of the second transistor (T2),
a lower potential (Ground) is present at the emitter of the first transistor (T1) and an upper potential (V+) is present at the collector of the second transistor (T2),
characterised
in that the emitter of the first transistor (T1) is directly connected to the emitter of the second transistor (T2) via a resistor (R4), and
the collector of the first transistor (T1) is connected to a second output (Out-B) via a resistor (R5).

2. Integrated microwave silicon module according to Claim 1,
characterised
in that an RC element is connected between the base and collector of the first transistor (T1).

3. Integrated microwave silicon module according to one of the preceding claims,
characterised
in that the module (1) serves for constructing an amplifier.

4. Integrated microwave silicon module according to Claim 3,
characterised
in that a capacitance is connected between the first and second circuit outputs.

5. Integrated microwave silicon module according to Claim 3,
characterised
in that the amplified voltage is tapped off at the first circuit output (Out-B) downstream of a series resistor.

6. Integrated microwave silicon module according to Claim 3,
characterised
in that the amplified voltage is tapped off at the second circuit output (Out-B) downstream of a series resistor

7. Integrated microwave silicon module according to Claim 3,
characterised
in that a capacitor is connected to earth at the first circuit output (Out-A) and the amplified signal is output at the upper potential terminal (B+).

8. Integrated microwave silicon module according to Claim 1 or 2
characterised
in that the module (1) can be used as a mixer.

9. Integrated microwave silicon module according to Claim 8,
characterised
in that the local oscillator is supplied at the first circuit output (Out-A) via a capacitance and an earthed inductance and an intermediate frequency can be picked off at the upper potential input (V+) via a matching network.

10. Integrated microwave silicon module according to Claim 1 or 2,
characterised
in that the module (1) can be used as an oscillator.

11. Integrated microwave silicon module according to Claim 10,
characterised
in that feedback to the circuit input (IN) takes place via the second circuit output (Out-B) and the oscillator output signal can be picked off via the second circuit output downstream of a capacitance.

## Revendications

1. Module intégré hyperfréquence en silicium avec un circuit de transistor, dans lequel la base d'un premier transistor (T1) est raccordée à l'entrée (IN) du circuit, la base d'un deuxième transistor (T2) est reliée au collecteur du premier transistor (T1), l'émetteur du deuxième transistor est relié à une première sortie (Out-A) du circuit,
une résistance (R2, R3) se trouve entre la base et le collecteur du premier transistor (T1) et du deuxième transistor (T2), un potentiel inférieur (Ground) s'applique à l'émetteur du premier transistor (T1) et un potentiel (V+) supérieur s'applique au collecteur du deuxième transistor (T2),
caractérisé
en ce que l'émetteur du premier transistor (T1) est relié par l'intermédiaire d'une résistance (R4) directement à l'émetteur du deuxième transistor (T2) et en ce que le collecteur du premier transistor (T1) est relié par l'intermédiaire d'une résistance (R4) directement à l'émetteur du deuxième transistor (T2) et
en ce que le collecteur du premier transistor (T1) est relié par l'intermédiaire d'une résistance (R5) à une deuxième sortie (Out-B).

2. Module intégré hyperfréquence en silicium suivant la revendication 1, caractérisé en ce qu'un élément (RC) est branché entre la base et le collecteur du premier transistor (T1).

3. Module intégré hyperfréquence en silicium suivant l'une des revendications précédentes , caractérisé en ce que le module (1) sert à réaliser un amplificateur.

4. Module intégré hyperfréquence en silicium suivant la revendication 3, caractérisé en ce qu'une capacité est branchée entre la première et la deuxième sortie du circuit.

5. Module intégré hyperfréquence en silicium suivant la revendication 3, caractérisé en ce que la tension amplifiée est prélevée à la première sortie (Out-B) du circuit en aval d'une résistance en série.

6. Module intégré hyperfréquence en silicium suivant la revendication 3, caractérisé en ce que la tension amplifiée est prélevée à la deuxième sortie (Out-B) du circuit en aval d'une résistance en série.

7. Module intégré hyperfréquence en silicium suivant la revendication 3, caractérisé en ce qu'un condensateur est branché à la masse à la première sortie (Out-A) du circuit et en ce que la sortie du signal amplifié s'effectue sur la borne (V+) de potentiel supérieur.

8. Module intégré hyperfréquence en silicium suivant la revendication 1 ou 2, caractérisé en ce que le module (1) peut être utilisé comme mélangeur.

9. Module intégré hyperfréquence en silicium suivant la revendication 8, caractérisé en ce que l'oscillateur local est alimenté à la première sortie (Out-A) du circuit par l'intermédiaire d'une capacité et d'une inductance placée à la terre et en ce qu'une fréquence intermédiaire peut être prélevée à l'entrée (V+) de potentiel par l'intermédiaire d'un système d'adaptation.

10. Module intégré hyperfréquence en silicium suivant la revendication 1 ou 2, caractérisé en ce que le module (1) peut être utilisé comme oscillateur.

11. Module intégré hyperfréquence en silicium suivant la revendication 10, caractérisé en ce qu'un rétrocouplage avec l'entrée (IN) du circuit a lieu par l'intermédiaire de la deuxième sortie (Out-B) du circuit et en ce que le signal de sortie de l'oscillateur peut être prélevé par l'intermédiaire de la deuxième sortie du circuit en aval d'une capacité.
